(19) Europäisches Patentamt
European Patent Office
Office européen des brevets

(11) **EP 2 045 813 A2**

(12) **EUROPEAN PATENT APPLICATION**

(43) Date of publication:
**08.04.2009 Bulletin 2009/15**

(51) Int Cl.:
**G11C 7/22** *(2006.01)*     **G11C 7/10** *(2006.01)*
**G11C 11/4076** *(2006.01)*

(21) Application number: **08158515.0**

(22) Date of filing: **18.06.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **28.09.2007   KR 20070098154**

(71) Applicant: **SAMSUNG ELECTRONICS CO., LTD. Suwon-si,
Gyeonggi-do 442-742 (KR)**

(72) Inventor: **Hwang, Sung-joo**
**103-703, Myeongsudae Hyundai Apartment Seoul (KR)**

(74) Representative: **Clark, David James
Appleyard Lees
15 Clare Road
Halifax
HX1 2HY (GB)**

(54) **Storage apparatus for using adaptive clock to temperature change and broadcast receiving apparatus using the same**

(57)     Provided are a storage apparatus in which a clock can be adapted according to temperature changes and a broadcast receiving apparatus using the same. The storage apparatus adjusts and uses a signal, which is used to read out data from a memory, according to the measured temperature. Accordingly, the storage apparatus can be prevented from erroneously reading data from the memory due to clock errors caused by temperature changes.

# FIG. 1

**Description**

CROSS-REFERENCE TO RELATED APPLICATIONS

BACKGROUND OF THE INVENTION

**1. Field of the Invention**

Apparatuses and methods consistent with the present invention relate to providing a storage apparatus and a broadcast receiving apparatus using the same, and more particularly but not exclusively, to providing a storage apparatus for storing and reading out data and a broadcast receiving apparatus using the same.

**2. Description of the Related Art**

Electronic devices typically have memories whereon data necessary to operate the electronic devices are stored, and read out and use the data stored in the memory.

A clock is required in order to drive the memory. That is, electronic devices write data to the memory using the clock, and read out necessary data from the memory using the clock.

The clock may be affected by changes in temperature. If the temperature increases or decreases significantly, the clock may be altered. If the clock is altered, data may be erroneously read out from the memory.

If data are erroneously read out, the electronic device may not be able to operate or may malfunction, so there is a need for a storage apparatus for using an clock able to adapt to temperature changes.

SUMMARY OF THE INVENTION

Exemplary embodiments of the present invention aim to address at least the above problems and/or disadvantages and other disadvantages not described above.

Exemplary embodiments of the present invention provide a storage apparatus wherein delays of a clock used for reading out data stored in a memory can be adjusted according to changes in temperature in order to prevent the storage apparatus from erroneously reading data from the memory due to clock alteration caused by temperature change, and a broadcast receiving apparatus using the same.

According to an exemplary aspect of the present invention, there is provided a storage apparatus including a temperature measuring unit which measures a temperature; and a memory control unit which adjusts a signal, which is used to read out data from a memory, according to the measured temperature.

The signal may be a clock, and the memory control unit may adjust a delay of the clock to provide a delay-adjusted clock, wherein the delay of the clock is adjusted according to the measured temperature.

The memory control unit may adjust the delay of the clock if the measured temperature is lower than a first temperature or higher than a second temperature.

The memory control unit may include a delay adjusting unit which adjusts the delay of the clock according to the measured temperature, and a reading unit which reads out the data from the memory using the delay-adjusted clock.

The temperature measuring unit may include a power source which outputs a predetermined level of voltage, and a thermistor resistance which has a resistance value which changes according to the temperature, and which divides the voltage output from the power source differently according to the temperature and transmits the voltage to the memory control unit.

The memory may be a Double Data Rate (DDR) memory. According to another exemplary aspect of the present invention, there is provided a method for controlling a memory, the method including measuring the temperature, and adjusting a signal, which is used to read out data from the memory, according to the measured temperature.

The signal may be a clock, and in the adjusting operation, the delay of the clock may be adjusted to provide a delay-adjusted clock, wherein the delay of the clock is adjusted according to the measured temperature.

In the adjusting operation, the delay of the clock may be adjusted if the measured temperature is lower than a first temperature or higher than a second temperature.

The method may further include reading out the data from the memory using the delay-adjusted clock.

The memory may be a Double Data Rate (DDR) memory. According to another exemplary aspect of the present invention, there is provided a memory control apparatus including a delay adjusting unit which adjusts the delay of a clock to provide a delay-adjusted clock, wherein the delay of the clock is adjusted according to a measured temperature, and a reading unit which reads out data from a memory using the delay-adjusted clock.

According to another exemplary aspect of the present invention, there is provided a broadcast receiving apparatus including a broadcast receiving unit which receives a broadcast, a broadcast processing unit which processes the broadcast received through the broadcast receiving unit, a temperature measuring unit which measures the temperature, a memory which provides a storage space for the broadcast processing unit to process the broadcast, and a memory control unit which adjusts a signal, which is used to read out data from the memory, according to the temperature measured by the temperature measuring unit.

According to the present invention there is provided an apparatus and method as set forth in the appended claims. Other features of the invention will be apparent from the dependent claims, and the description which follows.

## BRIEF DESCRIPTION OF THE DRAWINGS

The above and/or other aspects of the present invention will be more apparent by describing certain exemplary embodiments of the present invention with reference to the accompanying drawings, in which:

FIG. 1 is a block diagram of a storage apparatus according to an exemplary embodiment of the present invention;

FIGS. 2A to 2C are drawings illustrating alteration of a data strobe (DQS) due to temperature change;

FIG. 3 illustrates an example of the temperature measuring unit shown in FIG. 1;

FIG. 4 is a flow chart illustrating a method for controlling a memory according to an exemplary embodiment of the present invention; and

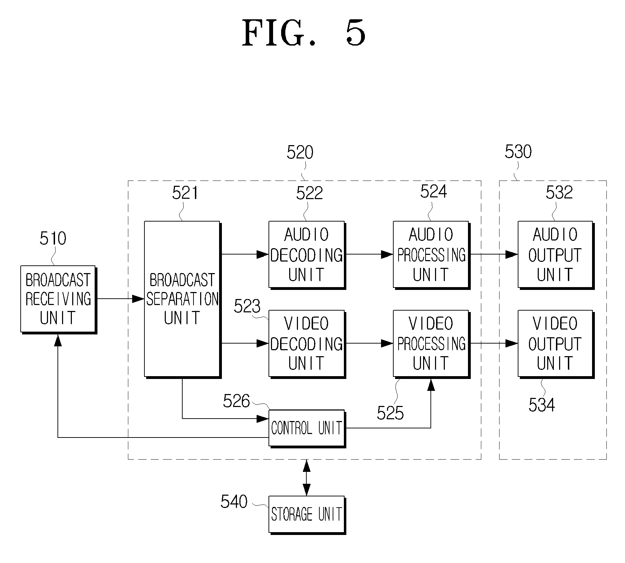

FIG. 5 is a block diagram of a digital television using the storage apparatus in FIG. 1.

## DETAILED DESCRIPTION OF EXEMPLARY EMBODIMENTS OF

## THE INVENTION

Certain exemplary embodiments of the present invention will now be described in greater detail with reference to the accompanying drawings.

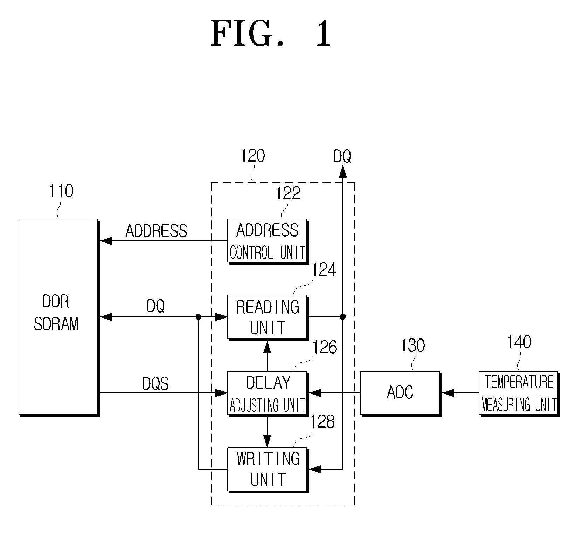

FIG. 1 is a block diagram of a storage apparatus according to an exemplary embodiment of the present invention. The storage apparatus adaptively adjusts the delay of a clock used to read out data stored in a memory according to the change of temperature.

The storage apparatus includes a Double Data Rate (DDR) Synchronous Dynamic Random Access Memory (SDRAM) 110, a memory control unit 120, an analog to digital converter (ADC) 130, and a temperature measuring unit 140. The memory control unit 120 and the ADC 130 may be packaged in a single chip.

Although the exemplary embodiment includes the DDR SDRAM 110, a different type of DDR memory may be utilized.

The temperature measuring unit 140 measures the temperature, and transmits information on the temperature to the ADC 130. A detailed description of the temperature measuring unit 140 will be provided below.

The temperature information output from the temperature measuring unit 140 is generated as an analog signal. The ADC 130 converts the temperature information from an analog signal into a digital signal, and transmits the temperature information in digital form to the memory control unit 120.

The memory control unit 120 writes DQ (data) to the DDR SDRAM 110, and reads out the DQ from the DDR SDRAM 110. Upon writing and reading out the DQ, the memory control unit 120 uses DQS (data strobe), which is a reference clock, to determine the logic level of the read-out DQ or the logic level of DQ to be written.

The memory control unit 120 adjusts the delay of the DQS based on the temperature information received from the temperature measuring unit 140 through the ADC 130, and includes an address control unit 122, a reading unit 124, a delay adjusting unit 126, and a writing unit 128.

In a reading mode, the address control unit 122 outputs the address of the DDR SDRAM 110 storing DQ to be read to the DDR SDRAM 110 so that the DQ is read out from the DDR SDRAM 110.

In a writing mode, the address control unit 122 outputs the address of the DDR SDRAM 110 to store DQ to the DDR SDRAM 110 so that the DQ is stored in the address of the DDR SDRAM 110.

The reading unit 124 operates in a reading mode, and reads the DQ read out from the DDR SDRAM 110 using the DQS and transmits the DQ to an external element. In greater detail, the reading unit 124 reads out the DQ at both rising edges and falling edges of the DQS.

The writing unit 128 operates in a writing mode, and writes DQ received from an external element to the DDR SDRAM 110. In greater detail, the writing unit 128 writes the DQ at both rising edges and falling edges of the DQS.

The delay adjusting unit 126 adjusts the delay of the DQS received from the DDR SDRAM 110 based on the temperature information received from the temperature measuring unit 140 through the ADC 130. The delay adjusting unit 126 may be implemented as a single delay element, a plurality of delay elements, or a Delay Locked Loop (DLL).

The delay of the DQS changes according to the temperature. If the temperature rises, the delay of the DQS decreases (that is, the timing of the DQS is fast), and if the temperature falls, the delay of the DQS increases (that is, the timing of the DQS is slow).

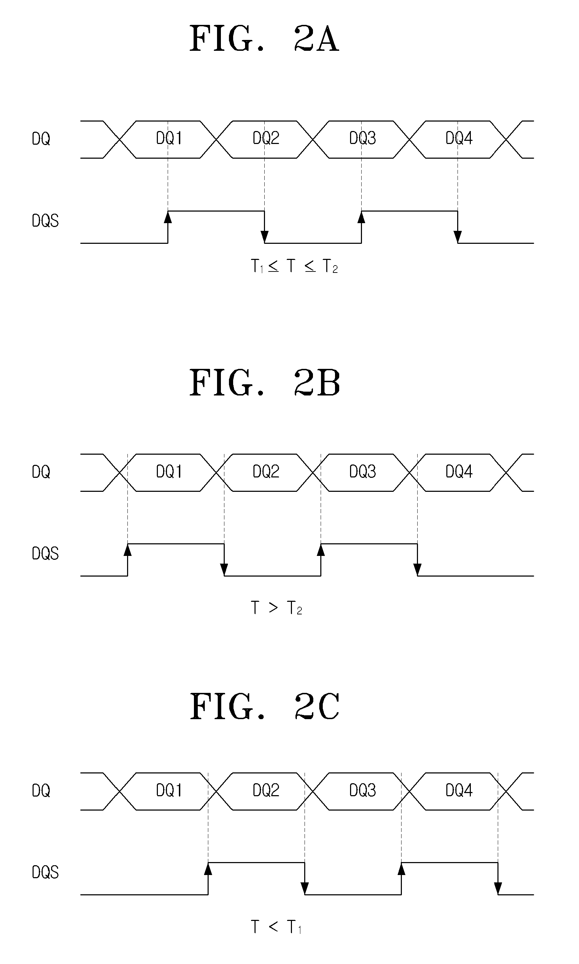

If the temperature (T) is within the reference temperature range ($T_1 \leq T \leq T_2$), the DQS is as shown in FIG. 2A. However, if the temperature rises ($T > T_2$), the delay of the DQS decreases as shown in FIG. 2B (that is, the timing of the DQS is fast), and if the temperature falls ($T < T_1$), the delay of the DQS increases as shown in FIG. 2C (that is, the timing of the DQS is slow).

If the delay of the DQS is as shown in FIG. 2A, the rising edges and falling edges of the DQS are located at the center of the DQ (DQ1, DQ1, DQ3, and DQ4) so that no errors occur in reading the DQ (DQ1, DQ1, DQ3, and DQ4) using the DQS.

However, if the delay of the DQS is as shown in FIG. 2B or FIG. 2C, the rising edges and falling edges of the DQS are located at the edges of the DQ (DQ1, DQ1, DQ3, and DQ4) so that errors may occur in reading the DQ (DQ1, DQ1, DQ3, and DQ4) using the DQS.

In order to prevent errors occurring in reading the DQ (DQ1, DQ1, DQ3, and DQ4), the delay adjusting unit 126 adjusts the delay of the DQS as shown in FIG. 2B or FIG. 2C so the delay may be as shown in FIG. 2A.

More specifically, the delay adjusting unit 126 determines the current temperature based on the temperature information received from the temperature measuring unit 140. If the delay adjusting unit 126 determines that the current temperature is high ($T > T_2$), the delay adjusting unit 126 increases the delay of the DQS (that is, slows down the timing of the DQS) so that the DQS as shown in FIG. 2B changes to that shown in FIG. 2A.

If the delay adjusting unit 126 determines that the current temperature is low ($T < T_1$), the delay adjusting unit 126 decreases the delay of the DQS (that is, speeds up the timing of the DQS) so that the DQS as shown in FIG. 2C changes to that shown in FIG. 2A.

The DQS adjusted by the delay adjusting unit 126 is applied to the reading unit 124 and the writing unit 128 so as to be used in reading and writing the DQ.

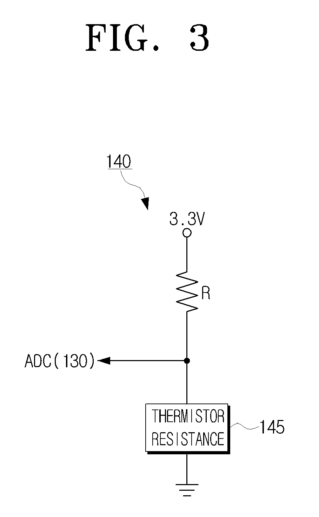

Detailed description of the temperature measuring unit 140 is given below with reference to FIG. 3, which illustrates an example of the temperature measuring unit 140. The temperature measuring unit 140 includes a power source 3.3V, a resistance R, and a thermistor resistance 145.

As shown in FIG. 3, the resistance R and the thermistor resistance 145 are connected in series. A first end of the thermistor resistance 145 is connected to an input end of the ADC 130, and a second end of the thermistor resistance 145 is grounded. Accordingly, power output from the power source 3.3V is divided and input to the input end of the ADC 130. The voltage of the power input to the input end of the ADC 130 is calculated using Equation 1.

[Equation 1]

$$Vin_{ADC} = \frac{R_T}{R + R_T} 3.3 [V]$$

In Equation 1, $Vin_{ADC}$ is an input voltage applied to the input end of the ADC 130, and $R_T$ is a resistance value of the thermistor resistance 145.

The thermistor resistance 145 is a resistance element having a resistance value which changes according to the temperature. If the temperature rises, the resistance value $R_T$ of the thermistor resistance 145 increases, and if the temperature falls, the resistance value $R_T$ of the thermistor resistance 145 decreases.

According to Equation 1, the input voltage $Vin_{ADC}$ of the ADC 130 is proportional to the resistance value $R_T$ of the thermistor resistance 145. Therefore, if the temperature rises, the resistance value $R_T$ of the thermistor resistance 145 increases and thus the input voltage $Vin_{ADC}$ of the ADC 130 increases. Alternatively, if the temperature falls, the resistance value $R_T$ of the thermistor resistance 145 decreases, and thus the input voltage $Vin_{ADC}$ of the ADC 130 decreases.

Consequently, the temperature measuring unit 140 provides an analog signal having a voltage level proportional to the current temperature to the ADC 130. The analog signal is a signal regarding the temperature information described above.

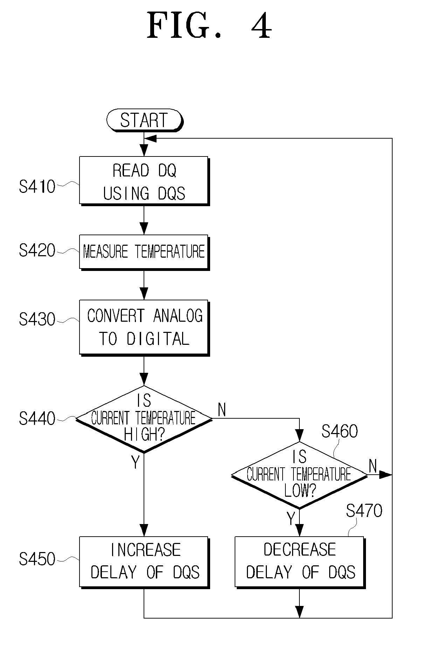

The process of the storage apparatus reading out DQ by adjusting the delay of DQS based on the current temperature as shown in FIG. 1 is described in detail with reference to FIG. 4, which is a flow chart illustrating a method for controlling a memory according to an exemplary embodiment of the present invention.

In operation S410 of FIG. 4, the reading unit 124 reads out DQ from the DDR SDRAM 110 using DQS transmitted from the delay adjusting unit 126.

In operation S420, the temperature measuring unit 140 measures the current temperature during operation S410, and transmits information on the measured temperature to the ADC 130.

In operation S430, the ADC 130 converts the temperature information from an analog signal into a digital signal, and transmits the digital signal regarding the temperature information to the delay adjusting unit 126 in the memory control unit 120.

In operations S440 and S460, the delay adjusting unit 126 determines the current temperature based on the temperature information transmitted from the temperature measuring unit 140 through the ADC 130.

If the delay adjusting unit 126 determines the current temperature to be high, i.e., higher than a threshold temperature value, in operation S440-Y, the delay adjusting unit 126 increases the delay of the DQS (that is, slows down the timing of the DQS) in operation S450. In more detail, the delay adjusting unit 126 changes the DQS wherein the delay is reduced (that is, the timing is fast) as in FIG. 2B, to be the DQS as shown in FIG. 2A. Subsequently, the operation returns to operation S410.

If the delay adjusting unit 126 determines the current temperature to be low, i.e., lower than another threshold temperature value, in operation S460-Y, the delay adjusting unit 126 decreases the delay of the DQS (that is, speeds up the timing of the DQS) in operation S470. In more detail, the delay adjusting unit 126 changes the DQS wherein the delay is raised (that is, the timing is slow) as in FIG. 2C, to be the DQS as shown in FIG. 2A. Subsequently, the operation returns to operation S410.

If the delay adjusting unit 126 determines the current temperature to be at an appropriate level (that is, the current temperature is neither high nor low) in operations S440-N and S460-N, the delay adjusting unit 126 does not adjust the delay of the DQS. Subsequently, the operation returns to operation S410.

The storage apparatus reading out DQ by adjusting the delay of DQS based on the current temperature and the process of the storage apparatus reading out DQ have been described in detail with regard to the exemplary embodiment.

In the exemplary embodiment, the case of reading data is stored in the DDR memory, but the technical idea of the present invention can also be applied in the case of memories other than the DDR memory.

In addition, in the exemplary embodiment, a clock, which is a kind of signal used to read data from a memory, is adjusted according to the temperature, but this is merely an example used for convenience of explanation. Accordingly, the technical idea of the present invention can be applied even when signals other than the clock are adjusted according to the temperature.

In addition, in the exemplary embodiment, the delay of the DQS may be adjusted so as to be proportional to the amount of temperature change. For example, if the amount of temperature change is large, the delay of the DQS may be adjusted by a large amount, and if the amount of temperature change is small, the delay of the DQS may be adjusted by a small amount.

Furthermore, in the exemplary embodiment, the storage apparatus is designed to decrease the delay of the DQS if the temperature rises, and to increase the delay of the DQS if the temperature falls. However, the storage apparatus may be designed to perform the reverse operations. That is, the technical idea of the present invention can also be applied to a storage apparatus which is designed to increase the delay of the DQS if the temperature rises, and to decrease the delay of the DQS if the temperature falls.

Furthermore, in the exemplary embodiment, the voltage of a signal output from the temperature measuring unit 140 is described as being proportional to the measured temperature, but this is merely an example provided for convenience of explanation. The technical idea of the present invention can be applied when the voltage of a signal output from the temperature measuring unit 140 is inversely proportional to the measured temperature.

In the exemplary embodiment, the temperature measuring unit 140 measures the current temperature using the thermistor resistance. However, the temperature measuring unit 140 also may measure the current temperature using elements other than the thermistor resistance.

Moreover, the lower limit $T_1$ and higher limit $T_2$ of the reference temperature range wherein errors do not occur upon reading DQ may be determined according to the features of the storage apparatus.

In the exemplary embodiment, the delay of the DQS used to read the DQ stored in the memory is adjusted according to the temperature, but this is merely an example provided for convenience of explanation. The technical idea of the present invention can also be applied when the delay of the DQS used to write DQ in the memory is adjusted according to the temperature.

The storage apparatus described above can be embedded in diverse electronic devices. One representative electronic device is a digital television, which is a kind of broadcast receiving apparatus. As shown in FIG.

5, the digital television comprises a broadcast receiving unit 510, a broadcast processing unit 520, a broadcast output unit 530, and a storage unit 540.

The broadcast receiving unit 510 tunes and demodulates the broadcast. The broadcast processing unit 520 processes a broadcast signal output from the broadcast receiving unit 510.

The broadcast processing unit 520 comprises a broadcast separation unit 521, an audio decoding unit 522, a video decoding unit 523, an audio processing unit 524, a video processing unit 525, and a control unit 526.

The broadcast separation unit 521 separates the broadcast signal output from the broadcast receiving unit 510 into an audio signal, a video signal, and additional data.

The audio decoding unit 522 decodes the audio signal output from the broadcast separation unit 521, and the audio processing unit 524 processes the decoded audio signal output from the audio decoding unit 522.

The video decoding unit 523 decodes the video signal output from the broadcast separation unit 521, and the audio processing unit 525 processes the decoded video signal output from the video decoding unit 523.

The control unit 526 controls the entire operation of the broadcast receiving unit 510 and the broadcast processing unit 520 according to the user's commands.

The output unit 530 comprises an audio output unit 532, and a video output unit 534. The audio output unit 532 outputs the audio signal output from the audio processing unit 524 through a speaker. The video output unit 534 outputs the video signal output from the video processing unit 525 on a display.

The storage unit 540 provides a storage space needed for the broadcast processing unit 520 to process the broadcast. That is, the storage unit 540 provides a storage space for decoding and processing the audio and video.

The storage unit 540 can be implemented as the storage apparatus shown in FIG. 1.

As can be appreciated from the above description, the delay of a clock which is used for reading out data stored in a memory can be adaptively adjusted according to temperature changes. Accordingly, the storage apparatus is prevented from erroneously reading data from the memory due to the clock being altered by temperature change, so the problem that the electronic device may be unable to be operated, or may malfunction can be solved.

Although a few preferred embodiments have been shown and described, it will be appreciated by those skilled in the art that various changes and modifications might be made without departing from the scope of the invention, as defined in the appended claims.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

**Claims**

1. A storage apparatus comprising:

   a temperature measuring unit (140) which measures a temperature; and
   a memory control unit (120) which adjusts a signal, which is used to read out data from a memory, according to the measured temperature.

2. The storage apparatus according to claim 1, wherein the signal is a clock, and the memory control unit (120) adjusts a delay of the clock according to the measured temperature.

3. The storage apparatus according to claim 2, wherein the memory control unit (120) adjusts the delay of the clock if the measured temperature is lower than a first temperature or higher than a second temperature.

4. The storage apparatus according to claim 2 or 3, wherein the memory control unit (120) comprises:

   a delay adjusting unit (126) which adjusts the delay of the clock to provide a delay adjusted clock, wherein the delay of the clock is adjusted according to the measured temperature; and
   a reading unit (124) which reads out the data from the memory using the delay adjusted clock.

5. The storage apparatus according to any one of claims 1 to 4, wherein the temperature measuring unit (140) comprises:

   a power source which outputs a predetermined level of voltage; and
   a thermistor resistance (145) which has a resistance value which changes according to the temperature, and which divides the voltage output from the power source differently according to the temperature and transmits the voltage to the memory control unit (120).

6. The storage apparatus according to any one of claims 1 to 5, wherein the memory is a Double Data Rate (DDR) memory.

7. A method for controlling a memory, the method comprising:

   measuring a temperature (S420); and
   adjusting a signal, which is used to read out data from the memory, according to the measured temperature (S440-S470).

8. The method according to claim 7, wherein the signal is a clock, and in the adjusting operation, a delay of the clock is adjusted to provide a delay adjusted clock, wherein the delay of the clock is adjusted according to the measured temperature.

9. The method according to claim 7 or 8, wherein in the adjusting operation, the delay of the clock is adjusted if the measured temperature is lower than a first temperature or higher than a second temperature.

10. The method according to claim 8 or 9 further comprising:

    reading out the data from the memory using the delay-adjusted clock (S410).

11. The method according to any one of claims 7 to 10, wherein the memory is a Double Data Rate (DDR) memory.

12. A memory control apparatus (120) adapted for use in the storage apparatus according to any one of claims 1 to 6, comprising:

    a delay adjusting unit (126) which adjusts a delay of a clock to provide a delay adjusted clock, wherein the delay of the clock is adjusted according to a measured temperature; and
    a reading unit (124) which reads out data from a memory using the delay-adjusted clock.

13. A broadcast receiving apparatus, comprising the storage apparatus according to any one of claims 1 to 6, further comprising:

    a broadcast receiving unit (510) which receives a broadcast; and

a broadcast processing unit (520) which processes a broadcast received through the broadcast receiving unit;

wherein the memory provides a storage space (540) for the broadcast processing unit to process the broadcast; and

wherein the memory control unit adjusts a signal which is used to read out data from the memory, according to the temperature measured by the temperature measuring unit.

# FIG. 1

# FIG. 2A

$$T_1 \leq T \leq T_2$$

# FIG. 2B

$$T > T_2$$

# FIG. 2C

$$T < T_1$$

# FIG. 3

# FIG. 4

START

S410 — READ DQ
USING DQS

S420 — MEASURE TEMPERATURE

S430 — CONVERT ANALOG
TO DIGITAL

S440 — IS
CURRENT TEMPERATURE
HIGH?

N

S460 — IS
CURRENT TEMPERATURE
LOW?

N

Y

S450 — INCREASE
DELAY OF DQS

Y

S470 — DECREASE
DELAY OF DQS

# FIG. 5